# EUROPEAN PATENT APPLICATION

(11) **EP 2 857 452 A1**
(43) Date of publication of application: **08.04.2015**
(21) Application number: 13801069.9
(22) Date of filing: 05.06.2013
(51) Int. Cl.: C08L 61/34, C08G 14/073, C09J 179/04

(54) **ADHESIVE COMPOSITION OR UNDERFILL COMPOSITION**

(30) Priority: 05.06.2012 JP 2012127829
(71) Applicant: Nissan Chemical Industries, Ltd., Chiyoda-ku Tokyo 101-0054 (JP)
(72) Inventor: OHASHI, Takuya, Toyama-shi Toyama 939-2792 (JP); ENOMOTO, Tomoyuki, Toyama-shi Toyama 939-2792 (JP)
(74) Representative: Hoffmann Eitle
(86) International application number: PCT/JP2013/065611
(87) International publication number: WO 2013/183679

(57) **Abstract**

There is provided a novel adhesive composition or underfill composition. An adhesive composition or an underfill composition comprising: a polymer that exclusively includes at least one structural unit of Formula (1) as a repeating unit except a terminal: 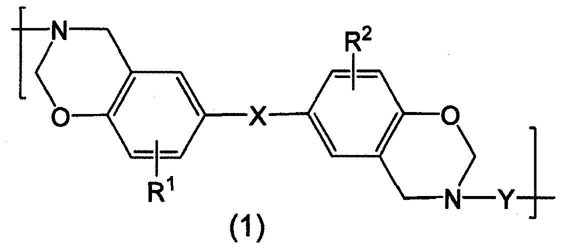 {where each of R¹ and R² is independently a hydrogen atom or a methyl group; X is a sulfonyl group or a divalent organic group of Formula (2): 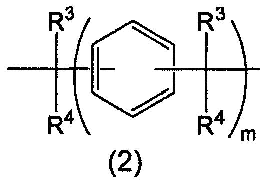 (where each of R³ and R⁴ is independently a hydrogen atom or a methyl group; at least one hydrogen atom of the methyl group is optionally substituted by a halogen atom; and m is 0 or 1), and Y is a divalent organic group of Formula (3) or Formula (4): 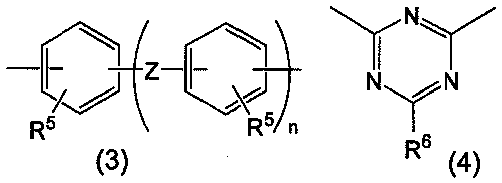 (where Z is a single bond, a methylene group, a sulfonyl group, an -O- group, or a divalent organic group of Formula (2) where m is 0; R⁵ is a hydrogen atom, a methyl group, an ethyl group, or a methoxy group; R⁶ is a methyl group, a vinyl group, an allyl group, or a phenyl group; and n is 0 or 1)}; and an organic solvent.

## Description

### TECHNICAL FIELD

The present invention relates to an adhesive composition or an underfill composition. More specifically, the present invention relates to an adhesive composition for bonding stacked materials to each other or an underfill composition used for flip-chip bonding in processes for manufacturing optical devices such as LEDs and CMOS image sensors and semiconductor devices typified by IC chips.

### BACKGROUND ART

In recent years, highly integrated semiconductor devices have been required for smaller and more sophisticated electronic devices such as cell phones and IC cards. To achieve such devices, micromachining of semiconductor elements and stack structures in which semiconductor elements are vertically stacked have been studied. To produce the stack structure, an adhesive is used to bond semiconductor elements to each other. However, acrylic resins, epoxy resins, and silicone resins, which are known adhesives, have a low heat resistance of about 250°C, and thus cannot be used in processes requiring a high temperature of 250°C or higher, such as electrode assembling of metal bumps and ion diffusing.

In the production of the stack structure, flip-chip bonding is known as a method of mounting an IC chip on a substrate. This bonding is a method of providing a plurality of bumps (protruding terminals) on an IC chip and electrically connecting the bumps to electrode terminals of a substrate. An underfill agent is used to fill the gap between the substrate and the IC chip and to protect the IC chip from moisture and external stress. The underfill agent used is a composition containing an epoxy resin (for example, Patent Document 1 and Patent Document 2). Conventionally, the underfill agent is typically injected after bump connection between a substrate and an IC chip (post-applied underfilling) and then is thermally cured. However, bumps having smaller sizes and smaller pitches and IC chips having larger sizes make the post-applying of an underfill agent difficult. To address this disadvantage, an underfill agent is previously formed on a wafer with bumps, then the wafer is diced, and the diced IC chip is subjected to flip-chip bonding. Such pre-applied underfilling will be mainly employed in the future.

A thermosetting resin composition containing a compound having a benzoxazine ring is known (for example, Patent Document 3), and the benzoxazine resin is known to have heat resistance. However, a dihydrobenzoxazine ring-containing compound contained in the resin composition for sealing described in Patent Document 3 is a monomer, and thus there is a risk of, for example, generation of voids due to the sublimation of the low molecular weight component during thermal curing and deterioration of the reliability due to the void generation.

### Prior Art Documents

### Patent Document

Patent Document 1: Japanese Patent No. 4887850 (JP 4887850 B2)
Patent Document 2: Japanese Patent No. 4931079 (JP 4931079 B2)
Patent Document 3: Japanese Patent No. 4570419 (JP 4570419 B2)

### SUMMARY OF THE INVENTION

### Problem to be Solved by the Invention

An object of the present invention is to provide an adhesive composition or an underfill composition that does not require a temperature of 250°C or higher for thermal curing and generates no void during thermal curing.

### Means for Solving the Problem

The present invention provides an adhesive composition or an underfill composition comprising: a polymer that exclusively includes at least one structural unit of Formula (1) as a repeating unit except a terminal: 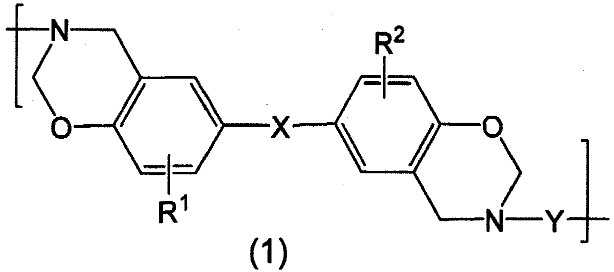 {where each of R¹ and R² is independently a hydrogen atom or a methyl group; X is a sulfonyl group or a divalent organic group of Formula (2): 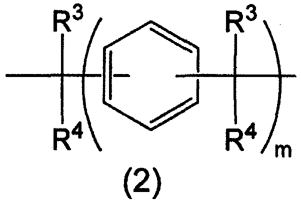 (where each of R³ and R⁴ is independently a hydrogen atom or a methyl group; at least one hydrogen atom of the methyl group is optionally substituted by a halogen atom; and m is 0 or 1), and Y is a divalent organic group of Formula (3) or Formula (4): 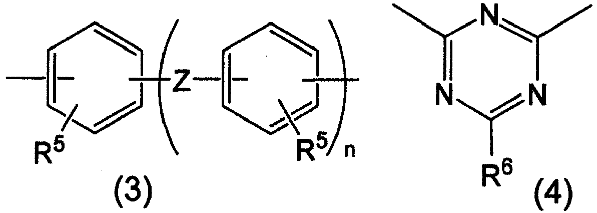 (where Z is a single bond, a methylene group, a sulfonyl group, an -O- group, or a divalent organic group of Formula (2) where m is 0; R⁵ is a hydrogen atom, a methyl group, an ethyl group, or a methoxy group; R⁶ is a methyl group, a vinyl group, an allyl group, or a phenyl group; and n is 0 or 1)}; and an organic solvent.

The halogen atom is exemplified by a fluorine atom.

The divalent organic group of Formula (2) is represented by, for example, Formula (2-a) or Formula (2-b):

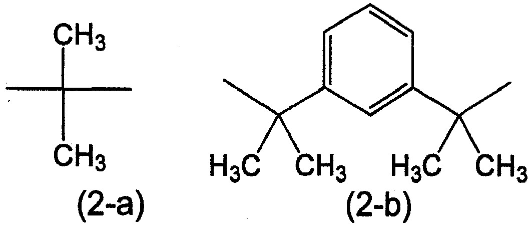

The divalent organic group of Formula (3) is represented by, for example, Formula (3-a), Formula (3-b), or Formula (3-c):

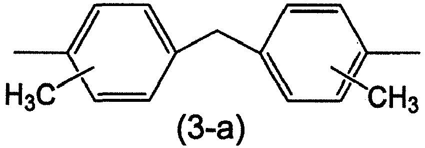

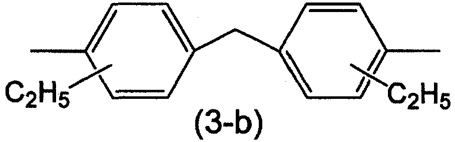

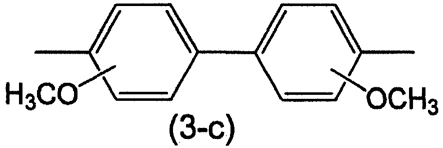

The polymer has a weight average molecular weight of 1,000 to 100,000 or 2,000 to 10,000, for example. The weight average molecular weight is a value determined by gel permeation chromatography (GPC) by using polystyrene as a standard sample.

The polymer is not limited to the cases of having a single type of the structural unit of Formula (1) but may have two types of the structural unit, for example.

### Effects of the Invention

The composition of the present invention can be cured at a comparatively low temperature of 200°C or lower. A film formed of the composition of the present invention generates no void, has good adhesiveness, is unlikely to cause exfoliation after adhesion, and has excellent heat resistance and low leakage current. The composition of the present invention is thus useful as an adhesive or an underfill agent.

### MODES FOR CARRYING OUT THE INVENTION

The adhesive composition or the underfill composition of the present invention is a coating solution of a polymer exclusively including at least one structural unit of Formula (1) as the repeating unit except terminals dissolving in an organic solvent. The coating solution has spin coating properties within the range of a solution viscosity of 0.001 to 5,000 Pa·s.

The organic solvent may be any solvents usable in processes of manufacturing semiconductor devices, and examples preferably used include ketones such as cyclohexanone, cyclopentanone, methyl isoamyl ketone, 2-butanone, and 2-heptanone; polyhydric alcohols and derivatives thereof, such as ethylene glycol, ethylene glycol monoacetate, diethylene glycol, diethylene glycol monoacetate, propylene glycol, propylene glycol monoacetate, dipropylene glycol, dipropylene glycol monoacetate, and monomethyl ethers, monoethyl ethers, monopropyl ethers, monobutyl ethers, and monophenyl ethers thereof; cyclic ethers such as dioxane; and esters such as methyl lactate, ethyl lactate, methyl acetate, ethyl acetate, butyl acetate, methyl pyruvate, ethyl pyruvate, methyl methoxypropionate, and ethyl ethoxypropionate. These solvents may be used singly or in combination of two or more of them.

The solid content, which is the ratio of the adhesive composition or the underfill composition of the present invention except the organic solvent, is 1% by mass to 70% by mass, for example.

The polymer included in the adhesive composition or the underfill composition of the present invention is obtained by, for example, causing a solution of a bisphenol compound, a diamine compound, and an aldehyde compound dissolved in a solvent to react under heat for a predetermined time.

Examples of the bisphenol compound include 2,2-bis(4-hydroxyphenyl)propane [bisphenol A], bis(4-hydroxyphenyl)sulfone [bisphenol S], 2,2-bis(4-hydroxyphenyl)hexafluoropropane [bisphenol AF], bis(4-hydroxyphenyl)methane [bisphenol F], 1,1-bis(4-hydroxyphenyl)ethane [bisphenol E], 1,3-bis[2-(4-hydroxyphenyl)-2-propyl]benzene [bisphenol M], 1,4-bis[2-(4-hydroxyphenyl)-2-propyl]benzene [bisphenol P], and 2,2'-bis(4-hydroxy-3-methylphenyl)propane.

Examples of the diamine compound include 4,4'-diamino-3,3'-dimethyldiphenylmethane, 4,4'-diamino-3,3'-diethyldiphenylmethane, 4,4'-diamino-3,3',5,5'-tetramethyldiphenylmethane, o-dianisidine, o-phenylenediamine, m-phenylenediamine, p-phenylenediamine, bis[4-(3-aminophenoxy)phenyl]sulfone, 3,3'-sulfonyldianiline, 4,4'-sulfonyldianiline, 2,4-diamino-1,3,5-triazine, 2,4-diamino-6-vinyl-1,3,5-triazine, and 2,4-diamino-6-methyl-1,3,5-triazine.

Examples of the aldehyde compound include paraformaldehyde and formaldehyde.

Examples of the solvent include toluene, xylenes, dioxane, tetrahydrofuran, chloroform, dichloromethane, cyclohexanone, cyclopentanone, methyl ethyl ketone, and N-methyl-2-pyrrolidone.

The adhesive composition or the underfill composition of the present invention may further contain additives such as an inorganic filler, a silane coupling agent, a surfactant, a rheology control agent, and a crosslinking agent, as necessary.

Examples of the inorganic filler include sols of silica, aluminum nitride, boron nitride, zirconia, alumina, and other inorganic substances having a particle diameter of 700 nm or smaller.

Examples of the silane coupling agent include vinyltrimethoxysilane, vinyltriethoxysilane, 3 -methacryloxypropyltriethoxysilane, 3-methacryloxypropyltrimethoxysilane, 3-glycidoxypropyltrimethoxysilane, 3-glycidoxypropyltriethoxysilane, 3-aminopropyltriethoxysilane, and 3-aminopropyltrimethoxysilane.

Examples of the rheology control agent include phthalic acid derivatives such as dimethyl phthalate, diethyl phthalate, diisobutyl phthalate, dihexyl phthalate, and butyl isodecyl phthalate; adipic acid derivatives such as di-n-butyl adipate, diisobutyl adipate, diisooctyl adipate, and octyl decyl adipate; maleic acid derivatives such as di-n-butyl maleate, diethyl maleate, and dinonyl maleate; oleic acid derivatives such as methyl oleate, butyl oleate, and tetrahydrofurfuryl oleate; and stearic acid derivatives such as n-butyl stearate and glyceryl stearate.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkylaryl ethers such as polyoxyethylene octylphenyl ether and polyoxyethylene nonylphenyl ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorochemical surfactants including EFTOP (registered trademark) EF301, EFTOP EF303, and EFTOP EF352 (manufactured by Mitsubishi Materials Electronic Chemicals Co., Ltd.), MEGAFAC (registered trademark) F171, MEGAFAC F173, MEGAFAC R30, and MEGAFAC R30N (manufactured by DIC Corporation), Fluorad FC 430 and Fluorad FC431 (manufactured by Sumitomo 3M Ltd.), and Asahiguard (registered trademark) AG710, Surflon (registered trademark) S-382, Surflon SC101, Surflon SC102, Surflon SC103, Surflon SC104, Surflon SC105, and Surflon SC106 (manufactured by Asahi Glass Co., Ltd.); and organosiloxane polymer KP341 (manufactured by Shin-Etsu Chemical Co., Ltd.). These surfactants may be added singly or in combination of two or more of them.

The adhesive composition or the underfill composition of the present invention does not necessarily contain the crosslinking agent. If used, the crosslinking agent is exemplified by nitrogen-containing compounds having a nitrogen atom that are substituted with an alkoxymethyl group such as a methoxymethyl group, an ethoxymethyl group, a butoxymethyl group, and a hexyloxymethyl group or a hydroxymethyl group. Other examples of the crosslinking agent include epoxy group-containing compounds, epoxy group-containing polymers, allyl group-containing compounds, allyl group-containing polymers, isocyanate group-containing compounds, and isocyanate group-containing polymers.

Examples of the nitrogen-containing compounds include nitrogen-containing compounds such as hexamethoxymethylmelamine, tetramethoxymethylbenzoguanamine, 1,3,4,6-tetrakis(butoxymethyl)glycoluril, 1,3,4,6-tetrakis(hydroxymethyl)glycoluril, 1,3-bis(hydroxymethyl)urea, 1,1,3,3-tetrakis(butoxymethyl)urea, 1,1,3,3-tetrakis(methoxymethyl)urea, 1,3-bis(hydroxyrnethyl)-4,5-dihydroxy-2-imidazolinone, and 1,3-bis(methoxymethyl)-4,5-dimethoxy-2-imidazolinone.

Examples of the crosslinking agent further include commercially available compounds such as methoxymethyl melamine compounds (trade name: CYMEL (registered trademark) 300, CYMEL 301, CYMEL 303, and CYMEL 350), butoxymethyl melamine compounds (trade name: Mycoat (registered trademark) 506 and Mycoat 508), glycoluril compounds (trade name: CYMEL (registered trademark) 1170 and POWDERLINK (registered trademark) 1174), a methylated urea resin (trade name: UFR65), and butylated urea resins (trade name: UFR300, U-VAN10S60, U-VAN10R, and U-VAN11HV) manufactured by Nihon Cytec Industries Inc. and urea/formaldehyde resins (highly condensed resins, trade name: Beckamine (registered trademark) J-300S, Beckamine P-955, and Beckamine N) manufactured by DIC Corporation.

The epoxy group-containing crosslinking agent may be a compound having at least one epoxy ring, for example, compounds having one to six epoxy rings or two to four epoxy rings. Examples of the compound include 1,4-butanediol diglycidyl ether, 1,2-epoxy-4-(epoxyethyl)cyclohexane, glycerol triglycidyl ether, diethylene glycol diglycidyl ether, 2,6-diglycidylphenyl glycidyl ether, 1,1,3-tris[p-(2,3-epoxypropoxy)phenyl]propane, 1,2-cyclohexanedicarboxylic acid diglycidyl ester, 4,4'-methylenebis(N,N-diglycidylaniline), 3,4-epoxycyclohexylmethyl-3,4-epoxycyclohexane carboxylate, trimethylolethane triglycidyl ether, triglycidyl-p-aminophenol, tetraglycidyl-m-xylenediamine, tetraglycidyldiaminodiphenylmethane, tetraglycidyl-1,3-bis-aminomethylcyclohexane, bisphenol-A-diglycidyl ether, bisphenol-S-diglycidyl ether, pentaerythritol tetraglycidyl ether resorcinol diglycidyl ether, diglycidyl phthalate, neopentyl glycol diglycidyl ether, polypropylene glycol diglycidyl ether, tetrabromobisphenol-A-diglycidyl ether, bisphenol hexafluoroacetone diglycidyl ether, pentaerythritol diglycidyl ether, tris-(2,3-epoxypropyl) isocyanurate, monoallyl diglycidyl isocyanurate, diglycerol polydiglycidyl ether, pentaerythritol polyglycidyl ether, 1,4-bis(2,3-epoxypropoxyperfluoroisopropyl)cyclohexane, sorbitol polyglycidyl ether, trimethylolpropane polyglycidyl ether, resorcin diglycidyl ether, 1,6-hexanediol diglycidyl ether, polyethylene glycol diglycidyl ether, phenyl glycidyl ether, p-tertiary butylphenyl glycidyl ether, adipic acid diglycidyl ether, o-phthalic acid diglycidyl ether, dibromophenyl glycidyl ether, 1,2,7,8-diepoxyoctane, 1,6-dimethylolperfluorohexane diglycidyl ether, 4,4'-bis(2,3-epoxypropoxyperfluoroisopropyl)diphenyl ether, 2,2-bis(4-glycidyloxyphenyl)propane, 3,4-epoxycyclohexylmethyl-3',4'-epoxycyclohexane carboxylate, 3,4-epoxycyclohexyloxirane, 2-(3,4-epoxycyclohexyl)-3',4'-epoxy-1,3-dioxane-5-spirocyclohexane, 1,2-ethylenedioxy-bis(3,4-epoxycyclohexylmethane), 4',5'-epoxy-2'-methylcyclohexylmethyl-4,5-epoxy-2-methylcyclohexane carboxylate, ethylene glycol-bis(3,4-epoxycyclohexane carboxylate), bis-(3,4-epoxycyclohexylmethyl) adipate, bis(2,3-epoxycyclopentyl) ether, tetra(3,4-epoxycyclohexylmethyl) butanetetracarboxylate-modified ε-caprolactone, ε-caprolactone-modified 3',4'-epoxycyclohexylmethyl-3,4-epoxycyclohexane carboxylate, 1,2-epoxy-4-vinylcyclohexane, 1,2-epoxy-4-(2-methyloxiranyl)-1-methylcyclohexane, 1,2-epoxy-4-(2-oxiranyl)cyclohexane adducts of 2,2-bis(hydroxymethyl)-1-butanol, epoxidized polybutadienes, 3,4-epoxycyclohexylmethyl methacrylate, polyglycidyl methacrylate, epoxidized products of styrene-butadiene block copolymers, and polyphenol glycidyl ether-derived resins.

These crosslinking agents may be used singly or in combination of two or more of them. The crosslinking agent can be used in an amount of 1 % by mass to 50% by mass, 8% by mass to 40% by mass, or 15% by mass to 30% by mass relative to the amount of the polymer included in the adhesive composition or the underfill composition of the present invention.

The adhesive composition or the underfill composition of the present invention may contain a crosslinking catalyst together with the crosslinking agent. The crosslinking catalyst is used to accelerate the reaction by the crosslinking agent.

Examples of the crosslinking catalyst include p-toluenesulfonic acid, trifluoromethanesulfonic acid, methanesulfonic acid, pyridinium p-toluenesulfonate, salicylic acid, camphorsulfonic acid, 5-sulfosalicylic acid, citric acid, benzoic acid, hydroxybenzoic acids, 4-chlorobenzenesulfonic acid, 4-hydroxybenzenesulfonic acid, benzenedisulfonic acid, and 1-naphthalenesulfonic acid. These crosslinking catalysts may be used singly or in combination of two or more of them. The crosslinking catalyst can be used in an amount of 0.01 % by mass to 10% by mass, 0.05% by mass to 8% by mass, 0.1% by mass to 5% by mass, 0.3% by mass to 3% by mass, or 0.5% by mass to 1 % by mass relative to the amount of the polymer included in the adhesive composition or the underfill composition of the present invention.

The adhesive composition or the underfill composition of the present invention may further contain miscible additives including common additives such as an additional resin for improving performance of an adhesive, a tackifier, a plasticizer, an adhesion aid, a stabilizer, a coloring agent, and a defoaming agent within a range not to impair essential characteristics in the present invention.

Examples of the additional resin (polymer) for improving performance of an adhesive include addition polymers and polycondensation polymers such as polyester, polystyrene, polyimide, acrylic polymer, methacryl polymer, polyvinyl ether, phenol novolac, naphthol novolac, polyether, polyamide, and polycarbonate. Polymers having an aromatic ring such as a benzene ring, a naphthalene ring, an anthracene ring, a triazine ring, a quinoline ring, and a quinoxaline ring are preferably used. The polymer having a triazine ring is exemplified by polyesters having the structural unit of Formula (5). 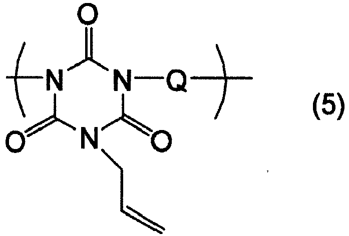 (In the formula, Q is a divalent organic group)

Examples of the additional resin (polymer) include addition polymers containing, as the structural unit, an addition polymerizable monomer such as benzyl acrylate, benzyl methacrylate, phenyl acrylate, naphthyl acrylate, anthryl methacrylate, anthrylmethyl methacrylate, styrene, hydroxystyrene, benzyl vinyl ether, and N-phenylmaleimide and polycondensation polymers such as phenol novolac and naphthol novolac. The additional resin (polymer) may be polymers having no aromatic ring. Examples of such a polymer include addition polymers exclusively containing, as the structural unit, an addition polymerizable monomer having no aromatic ring, such as alkyl acrylate, alkyl methacrylate, vinyl ether, alkyl vinyl ether, acrylonitrile, maleimide, N-alkyl maleimide, and maleic anhydride. When used as the additional resin (polymer), the addition polymer may be a homopolymer or a copolymer.

The additional resin (polymer) used in the adhesive composition or the underfill composition of the present invention has a molecular weight of, for example, 1,000 to 1,000,000, 3,000 to 300,000, 5,000 to 200,000, or 10,000 to 100,000 in terms of weight average molecular weight. If the additional resin (polymer) is contained in the adhesive composition or the underfill composition of the present invention, the amount is, for example, 40% by mass or less, 20% by mass or less, or 1 to 19% by mass in the solid content.

The tackifier is added to control elastic modulus, viscosity, and surface conditions. The tackifier is preferably selected in consideration of the viscosity Examples of the tackifier include aliphatic petroleum resins, aromatic petroleum resins, aliphatic/aromatic copolymerized petroleum resins, alicyclic hydrogenated petroleum resins, alkylphenol resins, xylene resins, coumarone indene resins, terpene resins, terpene phenol resins, aromatic-modified terpene resins, hydrogenated terpene resins, rosin resins, hydrogenated rosin resins, disproportionated rosin resins, dimerized rosin resins, and esterified rosin resins. These tackifiers may be used singly or in combination of two or more of them. The tackifier may be contained, for example, in a ratio of 100% by mass or less or 50% by mass or less relative to the amount of the polymer included in the adhesive composition or the underfill composition of the present invention.

### Examples

The present invention will next be described in further detail with reference to examples but is not limited to the examples.

The gel permeation chromatography (GPC) analysis of polymers obtained in Synthesis Examples described below was carried out with the following apparatus in the following conditions.
Apparatus: integral high-speed GPC system, HLC-8220GPC, manufactured by Tosoh Corporation
Column: KF-G, KF804L
Column temperature: 40°C
Solvent: tetrahydrofuran (THF)
Flow rate: 1.0 mL/min
Standard sample: polystyrene
Detector: RI

### <Synthesis Example 1>

In 70.37 g of N-methyl-2-pyrrolidone, 11.20 g of 4,4'-diamino-3,3'-dimethyldiphenylmethane (manufactured by Tokyo Chemical Industry Co., Ltd.), 12.56 g of bisphenol A (manufactured by Tokyo Chemical Industry Co., Ltd.), 5.29 g of paraformaldehyde (manufactured by Tokyo Chemical Industry Co., Ltd.), and 1.11 g of triethylamine were dissolved. The system was purged with nitrogen, and the mixture was allowed to react at 90°C for 20 hours, giving a solution containing a polymer. The obtained solution was then added dropwise to a mixed solution of water and methanol having a volume ratio of 1:9, giving a precipitate. The precipitate was collected by suction filtration through a Buchner funnel and washed with a mixed solution of water and methanol having a volume ratio of 1:9 twice. The obtained powder was dried in a vacuum dryer for 12 hours, yielding the polymer. GPC analysis of the obtained polymer revealed a weight average molecular weight of 2,500 in terms of standard polystyrene. The obtained polymer is supposed to have the structural unit of Formula (6).

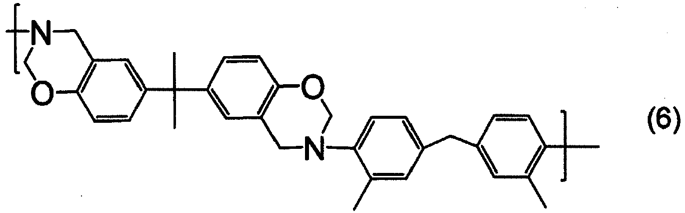

### <Synthesis Example 2>

In 69.98 g of N-methyl-2-pyrrolidone, 9.17 g of 4,4'-diamino-3,3'-dimethyldiphenylmethane (manufactured by Tokyo Chemical Industry Co., Ltd.), 15.59 g of bisphenol M (manufactured by Mitsui Fine Chemicals, Inc.), 4.32 g of paraformaldehyde (manufactured by Tokyo Chemical Industry Co., Ltd.), and 0.91 g of triethylamine were dissolved. The system was purged with nitrogen, and the mixture was allowed to react at 90°C for 20 hours, giving a solution containing a polymer. The obtained solution was then added dropwise to a mixed solution of water and methanol having a volume ratio of 1:9, giving a precipitate. After the dropwise addition, the precipitate was collected by suction filtration through a Buchner funnel and washed with a mixed solution of water and methanol having a volume ratio of 1:9 twice. The obtained powder was dried in a vacuum dryer for 12 hours, yielding the polymer. GPC analysis of the obtained polymer revealed a weight average molecular weight of 4,500 in terms of standard polystyrene. The obtained polymer is supposed to have the structural unit of Formula (7).

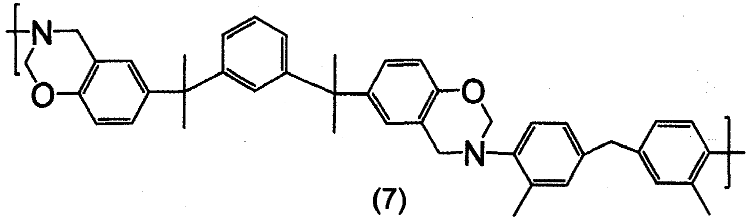

### <Synthesis Example 3>

In 69.18 g of N-methyl-2-pyrrolidone, 8.79 g of o-dianisidine (manufactured by Tokyo Chemical Industry Co., Ltd.), 9.13 g of bisphenol A (manufactured by Tokyo Chemical Industry Co., Ltd.), 4.32 g of paraformaldehyde (manufactured by Tokyo Chemical Industry Co., Ltd.), and 0.81 g of triethylamine were dissolved. The system was purged with nitrogen, and the mixture was allowed to react at 90°C for 20 hours, giving a solution containing a polymer. The obtained solution was then added dropwise to a mixed solution of water and methanol having a volume ratio of 1:9, giving a precipitate. After the dropwise addition, the precipitate was collected by suction filtration through a Buchner funnel and washed with a mixed solution of water and methanol having a volume ratio of 1:9 twice. The obtained powder was dried in a vacuum dryer for 12 hours, yielding the polymer. GPC analysis of the obtained polymer revealed a weight average molecular weight of 2,500 in terms of standard polystyrene. The obtained polymer is supposed to have the structural unit of Formula (8).

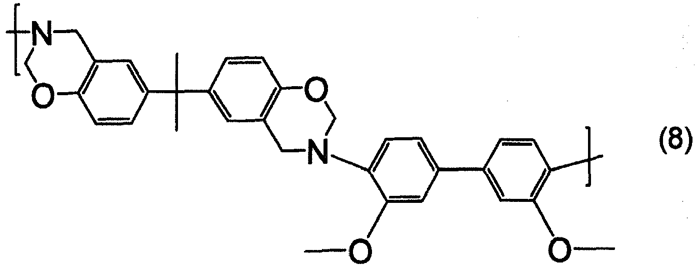

### <Synthesis Example 4>

In 74.26 g of N-methyl-2-pyrrolidone, 14.12 g of 4,4'-diamino-3,3'-dimethyldiphenylmethane (manufactured by Tokyo Chemical Industry Co., Ltd.), 6.66 g of 2,2'-bis(4-hydroxy-3-methylphenyl)propane (manufactured by Tokyo Chemical Industry Co., Ltd.), 1.98 g of bisphenol A (manufactured by Tokyo Chemical Industry Co., Ltd.), 2.91 g of paraformaldehyde (manufactured by Tokyo Chemical Industry Co., Ltd.), and 1.05 g of triethylamine were dissolved. The system was purged with nitrogen, and the mixture was allowed to react at 90°C for 20 hours, giving a solution containing a polymer. The obtained solution was then added dropwise to a mixed solution of water and methanol having a volume ratio of 1:9, giving a precipitate. After the dropwise addition, the precipitate was collected by suction filtration through a Buchner funnel and washed with a mixed solution of water and methanol having a volume ratio of 1:9 twice. The obtained powder was dried in a vacuum dryer for 12 hours, yielding the polymer. GPC analysis of the obtained polymer revealed a weight average molecular weight of 2,600 in terms of standard polystyrene. The obtained polymer is supposed to have the two structural units of Formula (9).

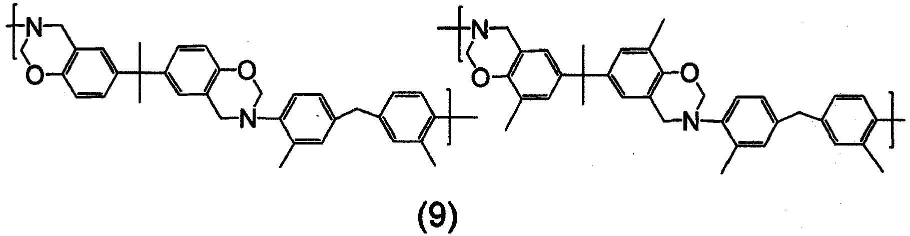

### <Comparative Synthesis Example 1>

In a flask equipped with a stirrer, a reflux condenser, a thermometer, and a dropping chamber, 15.00 g of 4,4'-dichlorodiphenyl-sulfone (manufactured by Tokyo Chemical Industry Co., Ltd.), 12.56 g of 2,2-bis(4-hydroxyphenyl)propane (manufactured by Tokyo Chemical Industry Co., Ltd.), 8.37 g of potassium carbonate, and 82.61 g of N-methyl-2-pyrrolidone were placed. The system in the flask was purged with nitrogen, and the mixture was heated to 160°C and allowed to react for 20 hours. The obtained reaction product was cooled to room temperature and filtered. The collected filtrate was mixed with 30 mL of a mixed solution of N-methyl-2-pyrrolidone and 2 mol/L hydrochloric acid having a volume ratio of 90:10. The mixture was poured into methanol and purified by reprecipitation. The precipitate was then washed with methanol and water, and dried under vacuum at 85°C for a day, yielding an aromatic polyether that was to be used in Comparative Example 3 and had the structural unit of Formula (10). GPC analysis of the obtained aromatic polyether revealed a weight average molecular weight of 16,700 in terms of standard polystyrene.

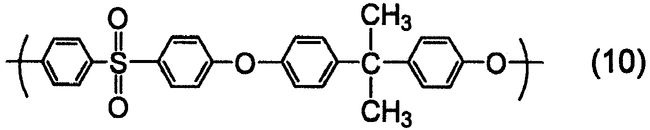

### <Comparative Synthesis Example 2>

In 51.99 g of chloroform, 10.39 g of α,α'-bis(4-hydroxyphenyl)-1,4-diisopropylbenzene (manufactured by Tokyo Chemical Industry Co., Ltd.), 8.62 g of 2,2-bis[4-(4-aminophenoxy)phenyl]propane (manufactured by Tokyo Chemical Industry Co., Ltd.), 2.66 g of paraformaldehyde (manufactured by Tokyo Chemical Industry Co., Ltd.), and 0.61 g of triethylamine were dissolved. The system was purged with nitrogen, and the mixture was allowed to react under reflux for 20 hours, giving a solution containing a polymer. The obtained solution was then added dropwise to ethanol, giving a precipitate. The precipitate was collected by suction filtration through a Buchner funnel and washed with ethanol twice. The obtained powder was dried in a vacuum dryer for 12 hours, yielding the polymer. GPC analysis of the obtained polymer revealed a weight average molecular weight of 10,000 in terms of standard polystyrene. The obtained polymer is supposed to have the structural unit of Formula (11).

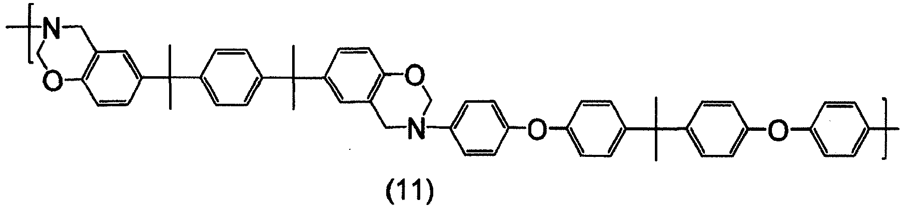

### <Comparative Synthesis Example 3>

In 51.56 g of chloroform, 6.54 g of 4,4'-diaminodiphenylmethane (manufactured by Tokyo Chemical Industry Co., Ltd.), 9.70 g of bisphenol A (manufactured by Tokyo Chemical Industry Co., Ltd.), 1.01 g of 4,4'-dihydroxybenzophenone (manufactured by Tokyo Chemical Industry Co., Ltd.), 4.18 g of paraformaldehyde (manufactured by Tokyo Chemical Industry Co., Ltd.), and 0.67 g of triethylamine were dissolved. The system was purged with nitrogen, and the mixture was allowed to react under reflux for 12 hours, giving a solution containing a polymer. The obtained solution was then added dropwise to methanol, giving a precipitate. The precipitate was collected by suction filtration through a Buchner funnel and washed with methanol twice. The obtained powder was dried in a vacuum dryer for 12 hours, yielding the polymer. GPC analysis of the obtained polymer revealed a weight average molecular weight of 117,000 in terms of standard polystyrene. The obtained polymer is supposed to have the two structural units of Formula (12).

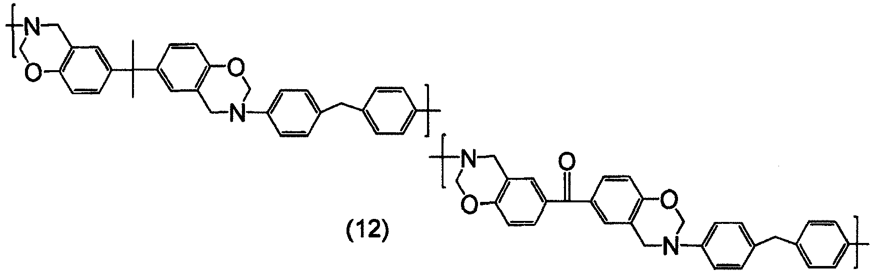

### <Example 1>

In 7.5 g of cyclohexanone, 5 g of the polymer obtained in Synthesis Example 1 was dissolved. The solution was filtered through a polyethylene microfilter having a pore diameter of 1.0 µm, thus giving a composition having a solid content of 40% by mass.

### <Example 2>

In 7.5 g of cyclohexanone, 5 g of the polymer obtained in Synthesis Example 2 was dissolved. The solution was filtered through a polyethylene microfilter having a pore diameter of 1.0 µm, thus giving a composition having a solid content of 40% by mass.

### <Example 3>

In 7.5 g of cyclohexanone, 5 g of the polymer obtained in Synthesis Example 3 was dissolved. The solution was filtered through a polyethylene microfilter having a pore diameter of 1.0 µm, thus giving a composition having a solid content of 40% by mass.

### <Example 4>

In 7.5 g of cyclohexanone, 5 g of the polymer obtained in Synthesis Example 4 was dissolved. The solution was filtered through a polyethylene microfilter having a pore diameter of 1.0 µm, thus giving a composition having a solid content of 40% by mass.

### <Comparative Example 1>

To 10 g of poly(pyromellitic dianhydride-co-4,4'-oxydianiline) amic acid solution (16% by mass Pyre-ML RC-5019 solution in N-methyl-2-pyrrolidone, manufactured by Sigma-Aldrich Japan) as a polyimide precursor, 10 g of N-methyl-2-pyrrolidone was added, and the mixture was filtered through a polyethylene microfilter having a pore diameter of 1.0 µm, giving a composition.

### <Comparative Example 2>

Polymethyl methacrylate (manufactured by Wako Pure Chemical Industries, Ltd.) as an acrylic resin was prepared. The polymethyl methacrylate was dissolved in cyclohexanone. The solution was filtered through a polyethylene microfilter having a pore diameter of 1.0 µm, thus giving a composition having a solid content of 20% by mass.

### <Comparative Example 3>

In N-methyl-2-pyrrolidone, the aromatic polyether obtained in Comparative Synthesis Example 1 was dissolved. The solution was filtered through a polyethylene microfilter having a pore diameter of 1.0 µm, thus giving a composition having a solid content of 10% by mass.

### <Comparative Example 4>

In 6.5 g of cyclohexanone, 3.5 g of the polymer obtained in Comparative Synthesis Example 2 was dissolved. The solution was filtered through a polyethylene microfilter having a pore diameter of 1.0 µm, thus giving a composition having a solid content of 35% by mass.

### <Comparative Example 5>

In 6.5 g of cyclohexanone, 3.5 g of the polymer obtained in Comparative Synthesis Example 3 was dissolved. The solution was filtered through a polyethylene microfilter having a pore diameter of 1.0 µm, thus giving a composition having a solid content of 35% by mass.

### [Solubility]

Each of the polymers used in Examples 1, 2, 3, and 4 (the polymers obtained in Synthesis Examples 1, 2, 3 and 4), the polymer compounds used in Comparative Examples 1, 2, and 3, and the polymers used in Comparative Examples 4 and 5 (the polymers obtained in Comparative Synthesis Examples 2 and 3) was dissolved in cyclohexanone. The polymer or the polymer compound dissolved at 35% by mass or more in cyclohexanone was evaluated as ○, and the polymer or the polymer compound dissolved at less than 35% by mass was evaluated as ×. Table 1 shows the results.

### [Dissolution Test in Solvent]

Each of the compositions prepared in Examples 1, 2, 3, and 4 and the compositions prepared in Comparative Examples 1, 2, and 3 was applied onto a silicon wafer with a spin coater. The coated wafer was placed on a hot plate and baked at 200°C for 5 minutes, giving a cured film having a film thickness of 1 µm. The film was immersed in N-methyl-2-pyrrolidone at 23°C for 2 minutes. A film having a change in film thickness of less than 5% was evaluated as ○, and a film having a change in film thickness of 5% or more was evaluated as ×. Table 1 shows the results. A composition giving the film evaluated as ○ is indicated to have curing properties at a low temperature (200°C).

### [Adhesiveness]

Each of the compositions prepared in Examples 1, 2, 3, and 4 and the compositions prepared in Comparative Examples 1, 2, 3, 4, and 5 was applied onto a silicon wafer having a size of 4 inch by spin coating in coating conditions at 1,000 rpm for 30 seconds. The coated wafer was baked at 100°C for 2 minutes and at 150°C for 2 minutes, giving a film. The film formed on the silicon wafer was then bonded to a 4-inch glass wafer by using a bonding apparatus (manufactured by Ayumi Industries Co., Ltd., VJ-300) in conditions at a vacuum pressure of 10 Pa or less, a temperature of 100°C (Example 1) or 160°C (Examples 2, 3 and 4 and Comparative Examples 1, 2, 3, 4, and 5), and an applied load of 800 kg. A film successfully bonded without voids was evaluated as ○, and a film giving voids and showing adhesion defect was evaluated as ×. Table 1 shows the results.

### [Heat Resistance after Adhesion]

The sample successfully bonded in the evaluation of adhesiveness was heated at 200°C for 5 minutes and then placed on a hot plate at 250°C to determine whether exfoliation occurred. A sample causing no exfoliation at 1 hour or more after the sample was placed on the hot plate was evaluated as ○, and a sample causing exfoliation within 1 hour was evaluated as ×. Table 1 shows the results.

### [Heat Resistance of Film]

Each of the compositions prepared in Examples 1, 2, 3, and 4 and the compositions prepared in Comparative Examples 1, 2, and 3 was applied onto a silicon wafer with a spin coater. The coated wafer was placed on a hot plate and baked at 200°C for 5 minutes, giving a cured film having a film thickness of 1 µm. The film formed was scraped from the silicon wafer. The collected film was heated with TG-DTA (manufactured by Bruker AXS GmbH, TG/DTA2010SR) at a temperature rise rate of 10°C/min, and the change in mass of the collected film was observed. The heat resistance was evaluated from a heat resistance temperature, at which the mass decrease reached 5% by mass. A film having a heat resistance temperature of 350°C or higher was evaluated as ○, and a film having a heat resistance temperature of lower than 350°C was evaluated as ×. Table 1 shows the results.

### [Leakage Current]

Each of the compositions prepared in Examples 1, 2, and 3 and the compositions prepared in Comparative Examples 1 and 2 was applied onto a silicon wafer with a spin coater. The coated wafer was placed on a hot plate and baked at 200°C for 5 minutes, giving a cured film having a film thickness of 500 nm. To the produced sample, an electric field of 1 MV/cm was applied with Cvmap 92B (manufactured by Four Dimensions Inc.), and the leakage current was determined. A sample having a current density of less than 1 × 10⁻⁹ A/cm² was evaluated as ○, and a sample having a current density of 1 × 10⁻⁹ A/cm² or more was evaluated as ×. Table 1 shows the results.

[Table 1]

| | Solubility | Dissolution in solvent | Adhesiveness | Heat resistance after adhesion | Film heat resistance | Leakage current |
|---|---|---|---|---|---|---|
| Example 1 | ○ | ○ | ○ | ○ | ○ | ○ |
| Example 2 | ○ | ○ | ○ | ○ | ○ | ○ |
| Example 3 | ○ | ○ | ○ | ○ | ○ | ○ |
| Example 4 | ○ | ○ | ○ | ○ | ○ | - |
| Comparative Example 1 | × | × | × | - | ○ | × |
| Comparative Example 2 | ○ | × | ○ | × | × | × |
| Comparative Example 3 | × | × | × | - | ○ | - |
| Comparative Example 4 | ○ | - | × | - | - | - |
| Comparative Example 5 | ○ | - | × | - | - | - |

The evaluation results of adhesiveness and heat resistance after adhesion shown in Table 1 revealed that the films formed of the compositions prepared in Examples 1, 2, 3, and 4 had better adhesiveness than those of the compositions prepared in Comparative Examples 1, 2, 3, 4, and 5. The evaluation results of dissolution in solvent, film heat resistance, and leakage current shown in Table 1 revealed that the compositions prepared in Examples 1, 2, 3, and 4 are usable as the underfill agent.

## Claims

1. An adhesive composition or an underfill composition comprising:
a polymer that exclusively includes at least one structural unit of Formula (1) as a repeating unit except a terminal: 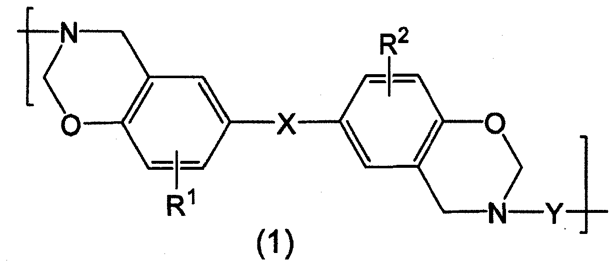 {where each of R¹ and R² is independently a hydrogen atom or a methyl group; X is a sulfonyl group or a divalent organic group of Formula (2): 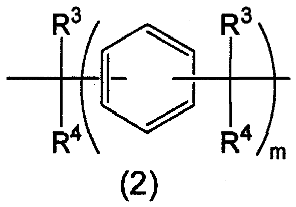 (where each of R³ and R⁴ is independently a hydrogen atom or a methyl group; at least one hydrogen atom of the methyl group is optionally substituted by a halogen atom; and m is 0 or 1), and Y is a divalent organic group of Formula (3) or Formula (4): 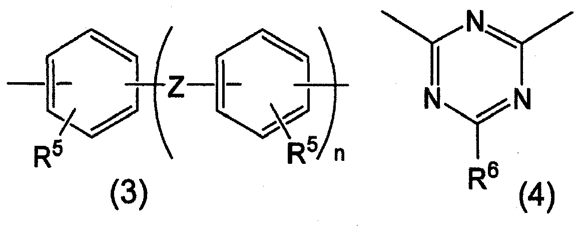 (where Z is a single bond, a methylene group, a sulfonyl group, an -O- group, or a divalent organic group of Formula (2) where m is 0; R⁵ is a hydrogen atom, a methyl group, an ethyl group, or a methoxy group; R⁶ is a methyl group, a vinyl group, an allyl group, or a phenyl group; and n is 0 or 1)}; and
an organic solvent.

2. The adhesive composition or the underfill composition according to claim 1, wherein
the divalent organic group of Formula (2) is represented by Formula (2-a) or Formula (2-b):

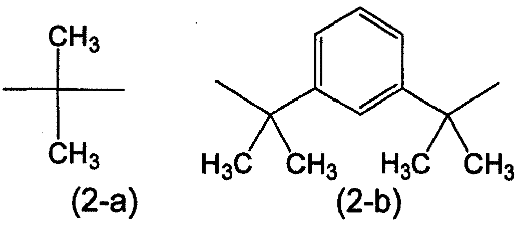

3. The adhesive composition or the underfill composition according to claim 1 or 2, wherein
the divalent organic group of Formula (3) is represented by Formula (3-a), Formula (3-b), or Formula (3-c):

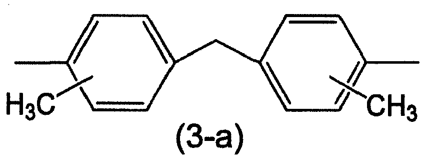

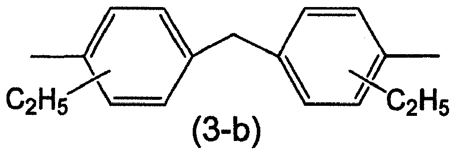

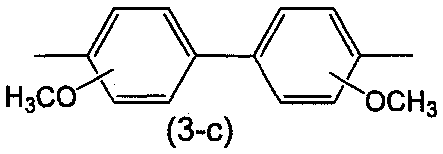

4. The adhesive composition or the underfill composition according to any one of claims 1 to 3, wherein
the polymer has a weight average molecular weight of 1,000 to 100,000.

5. The adhesive composition or the underfill composition according to any one of claims 1 to 4, wherein
the polymer has two types of the structural unit of Formula (1).

6. The adhesive composition or the underfill composition according to any one of claims 1 to 5, further comprising an inorganic filler.
